(19) Europäisches Patentamt
European Patent Office
Office européen des brevets

(11) EP 0 928 069 A2

(12) EUROPEAN PATENT APPLICATION

(43) Date of publication:
07.07.1999 Bulletin 1999/27

(51) Int Cl.⁶: H03K 19/096

(21) Application number: 98309421.0

(22) Date of filing: 18.11.1998

(84) Designated Contracting States:
AT BE CH CY DE DK ES FI FR GB GR IE IT LI LU
MC NL PT SE
Designated Extension States:
AL LT LV MK RO SI

(30) Priority: 31.12.1997 KR 9781005

(71) Applicant: Samsung Electronics Co., Ltd.
Suwon, Kyungi-do (KR)

(72) Inventor: Chung, Min-Chul
Ansan-shi, Kyunggi-do (KR)

(74) Representative: Mounteney, Simon James
MARKS & CLERK,
57-60 Lincoln's Inn Fields
London WC2A 3LS (GB)

(54) **Self-resetting dynamic logic circuits and method for resetting the same**

(57)    An S-R flipflop and a delay circuit are provided for a self-timed reset circuit to reset a dynamic logic circuit. The leading edge transition of an output signal is transferred to the set input of flipflop via the delay circuit to insure a desired output signal pulse width. But, the trailing edge transition of the output signal is directly fed back to the reset input of flipflop without delay in order to prepare for next operation cycle quickly.

Fig. 3

## Description

Field of the Invention

The present invention relates generally to logic circuits and, more particularly, to dynamic logic circuits having the capability of self-resetting and method for resetting the same.

Background of the Invention

Dynamic logic circuits perform logic operations using the properties of capacitive charge storage nodes. The operation of a dynamic logic circuit is divided by a clock into two distinct phases: the precharge and evaluate intervals. The clock signal provides logic synchronization and also allows predefined charge states to be established at a periodic rate. One or more outputs are defined only during a portion of the clock cycle. Such logic circuits are commonly utilized in processor logic. Typically, these circuits have been used to increase performance of logic circuits. But now the use of dynamic logic circuits have been extended to memory circuits.

Owing to their low power dissipation, complementary metal oxide semiconductor (CMOS) field effect transistors are often used to construct dynamic logic circuits. Dynamic CMOS logic circuits develop signals monotonically, or in one direction only. The presence or absence of charge on the evaluate node indicates the result of an evaluation. A single device polarity (usually NMOS transistor) is used predominantly in the evaluation path. Since the device size is optimized for that transition, capacitance can be dramatically reduced. There are fewer devices to drive, and those devices tend to be smaller.

One common logic cell in such dynamic CMOS logic circuits generally consists of a single PMOS transistor (precharge device) with a clock input to which a periodic clock pulse signal is applied, a logic circuit (usually NMOS circuit) with one or more logic inputs for receiving input signals, and a single NMOS transistor (evaluate device) with a clock input for receiving the same clock signal. During the precharge phase, the clock signal is at a logic low level ("0") so an output is connected to a supply voltage ($V_{DD}$) through the PMOS transistor and is therefore precharged to a logic high level ("1"). The evaluate happens when the clock signal goes to a logic high level. At this time, the PMOS transistor is turned off and the lowermost NMOS transistor (i.e., evaluate device) is turned on. Depending on the input values, the output either is discharged to a logic low level or remains at a logic high level. In either case, the correct output value is produced during the evaluate phase.

As described above, a dynamic logic circuit is driven by a clock signal to synchronize and to effect the associated logical function implemented in the logic circuit upon inputs. The clock signal also serves to precharge the logic circuit so that it is ready for the next series of signal inputs subsequent to outputting the previous output signal.

One problem with utilizing a clock signal to synchronize all logical operations within an integrated circuit, in which logic circuits are often cascaded in a plurality of connected stages, is that the overall system clock signal may be subjected to noise and clock skew while being transmitted throughout the integrated circuit, resulting in a distorted and inaccurate clock signal incorrectly driving any particular logic circuit.

A solution to the foregoing problem is the use of a reset circuit in order to precharge a logic circuit to a ready state so that it can accept input signals and perform the logical operation correctly. Examples of contemporary self-resetting dynamic CMOS logic circuits are disclosed in U.S. Pat. Nos. 4,751,407; 5,465,060; 5,467,037; 5,543,735; 5,550,490; 5,576,644; and 5,650,733, all of whose discloses are incorporated herein by reference. Such self-resetting dynamic logic circuits need no clock signal.

When such dynamic logic circuits having self-timed attributes are connected in series on a plurality of concatenated stages in semiconductor integrated circuits such as processors or memories, there may be a need to insure some reset (or precharge) timing margin for each circuit in order to guarantee its stable reset operation. With the advance of the stages, however, the reset timing margin of each stage may cause the respective stage output pulse widths to be increased gradually. Also, the output signal is directly affected by the input pulse width. For this reasons, it may be difficult to control the timing of the integrated circuit.

Summary of the Invention

It is therefore an object of the present invention to provide a self-resetting having a structure which can afford a convenience to controlling the timing of integrated circuit devices.

it is another object of the present invention to provide a self-resetting logic circuit suitable for high speed applications.

It is yet another object of the present invention to a self-resetting logic circuit capable of performing a stable reset operation.

It is yet another object of the present invention is to provide a reset circuit capable of resetting a logic circuit in high speed.

It is still another object of the present invention is to provide a method for resetting self-resetting logic circuits.

These and other objects, advantages and features of the present invention are provided by self-reset logic circuits which include a reset circuit for resetting a logic circuit in response to transitions of output signal OUT and independent of pulse width of respective input signals. The reset circuit includes an output feedback circuit which receives the output signal and transmits leading and trailing edge transitions ofthe output signal to next stage. A delay circuit of a predetermined delay time is provided for the reset circuit. An end of the delay circuit is coupled to the output feedback circuit. An S-R flipflop is also provided for the reset circuit. The flipflop has its set input coupled to the other end ofthe delay circuit, its reset input coupled to the output feedback circuit, and its output coupled to the logic circuit. The flipflop can be constructed with either NAND or NOR logic gates.

According to another aspect ofthe invention, a method for resetting a logic circuit which has one or more inputs for receiving one or more input signals and an output for providing an output signal is provided. The method comprises the steps of: detecting a leading edge of the output signal; producing a first reset signal in response to the detection ofthe leading edge ofthe output signal; delaying the first reset signal; resetting said logic circuit in response to the delayed first reset signal; detecting a trailing edge of the output signal; producing a second reset signal in response to the detection of the trailing edge of the output signal; and forcing said logic circuit to be ready for next input signals.

According to the present invention, the leading edge transition ofthe output signal is transferred to the set input of the S-R flipflop via the delay circuit to insure a desired output signal pulse width. But, the trailing edge transition ofthe output signal is directly fed back to the reset input of the flipflop without delay in order to prepare for next operation cycle quickly. Such a circuit configuration allows the self-resetting logic circuit ofthe invention to enter a reset state only depending on the leading edge transition ofthe output signal and independent of input pulse width although the delay time change due to process and/or environment variations occurs, thereby enabling stable reset operation to be performed and preventing operational errors in high speed applications.

Brief Description of the Drawings

A more complete appreciation ofthe present invention, and many ofthe attendant advantages thereof, will become readily apparent as the same becomes better understood by reference to the following detailed description when considered in conjunction with the accompanying drawings with like reference numerals indicating corresponding parts throughout, in which:

Fig. 1 illustrates an exemplary self-resetting dynamic logic circuit;
Figs. 2A and 2B are timing diagrams exemplifying operational errors ofthe circuit of Fig. 1;
Fig. 3 is a first embodiment of a self-resetting dynamic logic circuit according to the present invention;
Fig. 4 is a second embodiment of a self-resetting dynamic logic circuit according to the present invention;
Fig. 5 is a timing diagram illustrating the timing relationship between the signals at selected points of the logic circuit of Fig. 4;
Figs. 6 through 9 are third through sixth embodiments of a self-resetting dynamic logic circuit according to the present invention; and
Fig. 10 is a timing diagram illustrating the timing relationship between the signals at selected points of the circuit of Fig. 9.

Detailed Description of the Preferred Embodiments

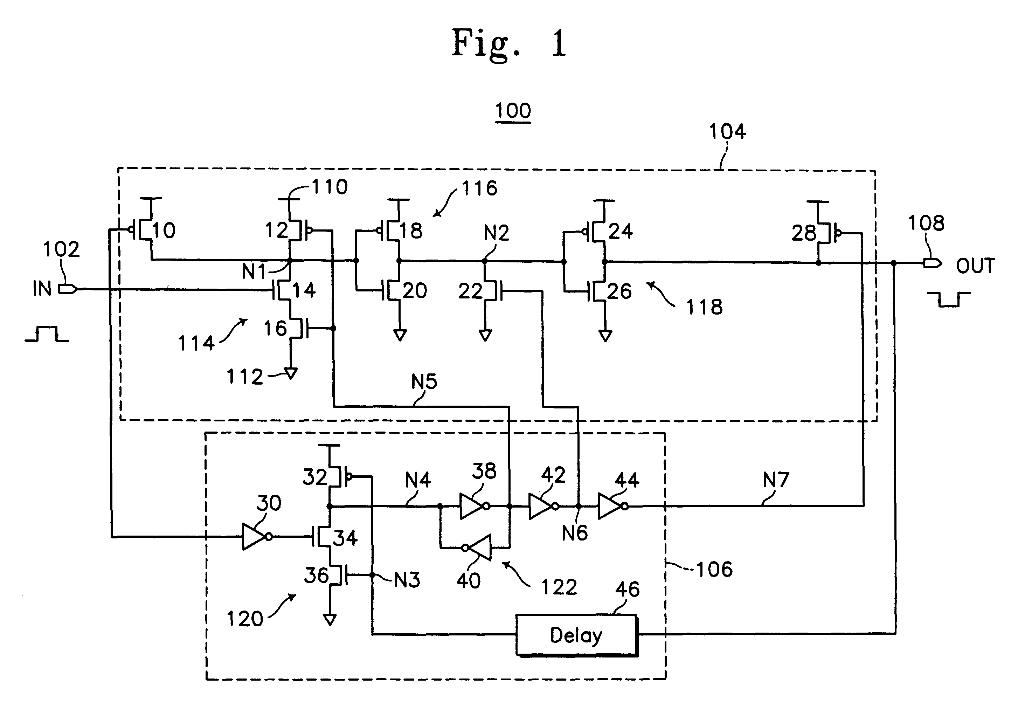

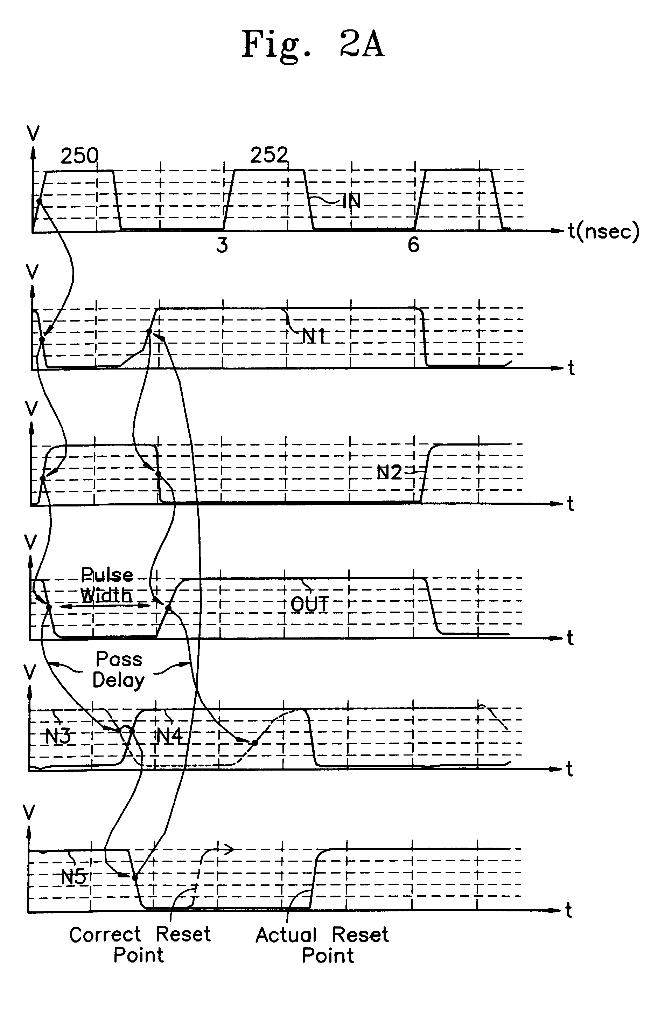

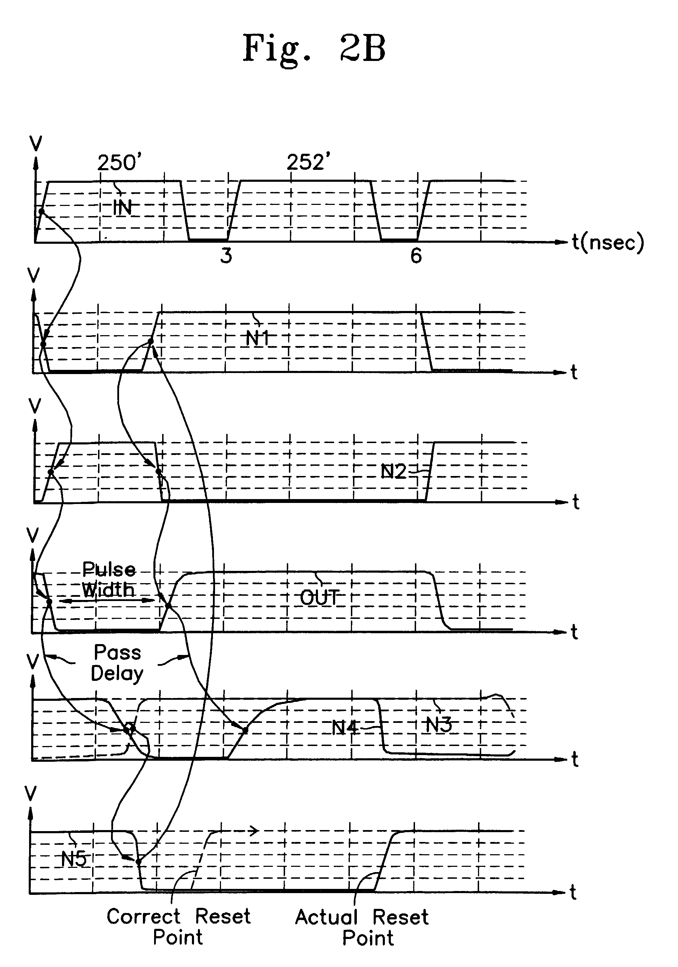

Before the description ofthe preferred embodiments, an exemplary self-resetting dynamic logic circuit will be explained with reference to Figs. 1, 2A and 2B.

Referring to Fig. 1, there is illustrated an exemplary self-resetting dynamic CMOS logic circuit 100, which is similar to the conventional logic circuits and is operable to perform a logical NOT operation. The self-resetting inverter circuit 100 includes a logic input terminal 102 for receiving an input signal IN, an inverter logic circuit 104 for performing a logical inverting operation with respect to the input signal IN, a reset circuit 106 for resetting the inverter logic circuit 104, and a logic output terminal 108 for providing an output signal OUT.

For the inverter logic circuit 104, a PMOS transistor 10 of a smaller size than the normal transistor size and a typical dynamic inverter 114 (consisting of one PMOS transistor 12 and two NMOS transistors 14 and 16) are provided. The conduction path (i.e., source-drain channel) of the transistor 10 is coupled between a supply voltage terminal 110 and a node N1. The input signal IN is commonly applied to gates of the transistors 10 and 14 via the input terminal 102. PMOS transistor 12 has its conduction path coupled between the supply voltage terminal 110 and the node N1. The conduction paths ofNMOS transistors 14 and 15 are connected in series between the node N1 and a ground voltage terminal 112. Both a standard CMOS static inverter 116 (consisting of a PMOS transistor 18 and a smaller NMOS transistor 20) and another inverter 118 (consisting of a smaller PMOS transistor 24 and a larger NMOS transistor 26) are connected in series between the node N1 and the logic output terminal 108. A larger NMOS transistor 22 has its conduction path coupled between the ground voltage terminal 112 and the junction node N2 of the inverters 116 and 118. A larger PMOS transistor 28 is provided between the inverter 118 and the logic output terminal 108 and has its conduction path coupled between the supply voltage terminal 110 and the logic output terminal 108.

A standard inverter 30 and a dynamic inverter 120 (consisting of one PMOS transistor 32 and two NMOS transistors 34 and 36) are provided for the reset circuit 106. Conduction paths of the transistors 32, 34 and 36 are connected in series between the supply voltage terminal 110 and the ground voltage terminal 112.

The input signal IN is also fed via the inverter 30 to the gate of NMOS transistor 34. An inverting latch 122 consisting of cross-coupled standard inverters 38 and 40 is provided between the drain junction node N3 of transistors 32 and 34 and a node N4 coupled to gates of the transistors 12 and 16. In addition, two standard inverters 42 and 44 are provided for the reset circuit 106. The inverter 42 has its input coupled to the node N5 and its output coupled a node N6 which is coupled to the gate of NMOS transistor 22. The inverter 44 has its input coupled to the node N6 and its output coupled to the gate ofPMOS transistor 28 via a node N7. Further, the output signal OUT is fed back to the reset circuit 106, and provided through a delay circuit 46 to a node N3 commonly coupled to gates of the transistors 32 and 36.

The operation of the self-resetting dynamic inverter logic circuit 100 will now be described below.

In a ready state, when input signal IN is at a logic low level, node N1 is charged by means of PMOS transistor 10 to a logic high level, so output signal OUT on terminal 108 is maintained high through inverters 116 and 118. With low level input signal IN and high level output signal OUT, NMOS transistors 34 and 36 within reset circuit 106 become conductive, so that nodes N4 and N6 are pulled down to a logic low level (i.e., about ground voltage $V_{SS}$), and nodes N5 and N7 are pulled up to a logic high level (i.e., about supply voltage $V_{DD}$). NMOS transistor 16 within inverter logic circuit 104 thus becomes conductive so as to be ready for the next logical operation.

When input signal IN is making a transition from a logic low level to a logic high level, node N1 is then discharged to a logic low level since NMOS transistors 14 and 16 both are conducting, thereby causing the output signal OUT to change from a logic high level to a logic low level. This high-to-low transition of the output signal OUT is fed back to node N3 via delay circuit 46, and thus node N4 goes high because PMOS transistor 32 conducts then. The logic high level on node N4 makes nodes N5 and N7 low and node N6 high. Owing to the logic low level at nodes N5 and N7 and the logic high level at node N6, the transistors 12, 22 and 28 are turned on, but the transistor 16 is turned off. Therefore, the inverter logic circuit 104 is reset by reset circuit 106. That is, the node N1 and the logic output terminal 108 are precharged high again. Like this, the logic circuit 100 itself enters reset state by use of its reset circuit 106.

The low-to-high transition of the output signal OUT on the terminal 108 is also sent to node N3 via the delay circuit 46, so that PMOS transistor 32 are turned off and NMOS transistor 36 on. At this time, because NMOS transistor 34 still remains in off state, with the help of latch 122, nodes N5, N6 and N7 remain in the same states (i.e., N5 and N7 are low and node N6 is high) while input signal IN is maintained at high level. But, if input signal IN transitions to low level again, then node N4 goes low since NMOS transistors 34 and 36 both are rendered conductive, making nodes N5 and N7 high and node N6 low. As a result, NMOS transistor 16 is turned on and PMOS transistor 28 off so that inverter logic circuit 104 is ready for the next pulse input of signal IN.

In the above-mentioned arrangement, if the reset time of the inverter logic circuit 104 is more delayed than designed due to process variations or other environments, such long delay may cause operational errors, as shown in Figs. 2A and 2B, which are timing diagrams exemplifying operational errors. As can be seen in Figs. 2A and 2B, although after a first pulse input 250 or 250' the inverter logic circuit 104 must be reset by the reset circuit 106 and so enter ready state in order to be ready for a second pulse input 252 (or 252'), the node N5 is still maintained low even after the second pulse input 252 (or 252'), so that the inverter logic circuit 104 cannot respond to the second pulse input 252 (or 252') and its output signal OUT erroneously remains high.

Accordingly, the above-mentioned arrangement may be unsuitable for high speed and high performance applications because of its long feedback delay time (the output feedback through the delay circuit 40 occurs twice a cycle time). Further, ifdynamic logic circuits with the above circuit configuration are connected in series on a plurality of connected stages in semiconductor integrated circuits, since the respective stage output pulse widths are increased gradually with the advance ofthe stages, controlling the timing of the integrated circuit may be very difficult.

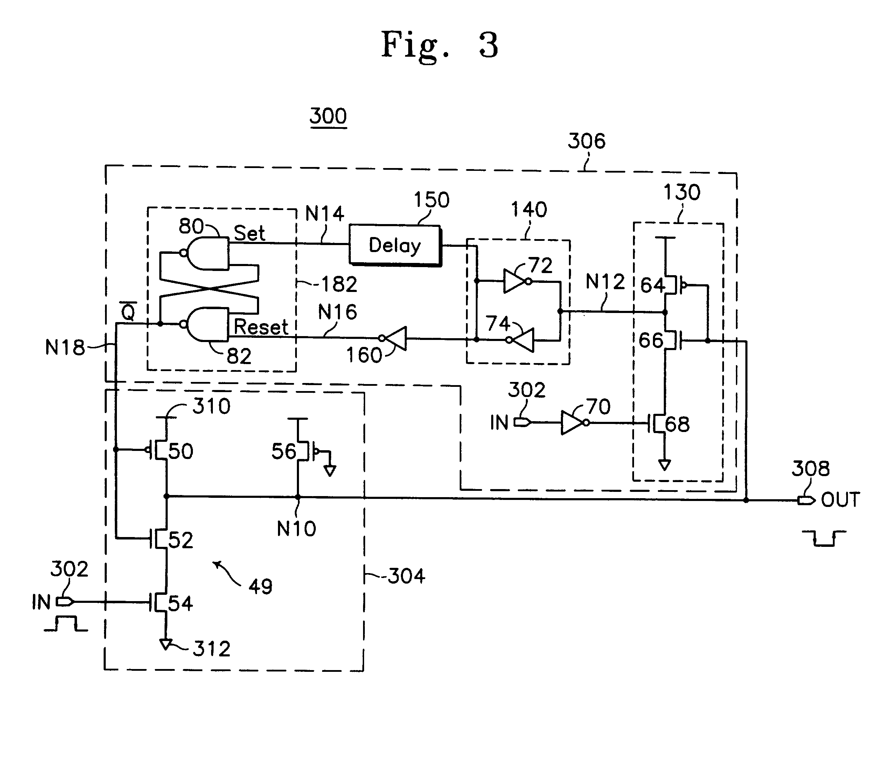

Hereinafter, preferred embodiments of the present invention will be described in detail with reference to Figs. 3 through 10. The following detailed description is the best modes presently contemplated by the inventors for practicing the invention. It should be understood that the description ofthese preferred embodiments is merely illustrative and that they should not be taken in a limiting sense. In the following description, like or similar reference symbols indicate the same or similar components.

Reference is now made to Fig. 3, which illustrates a first embodiment of a self-resetting dynamic circuit according to the present invention. The dynamic circuit 300 shown in Fig. 3 is a self-resetting dynamic inverter logic circuit, which includes an input terminal 302 for receiving an input signal IN, an inverter logic circuit 304 for inverting the input signal IN and providing an output signal OUT, a reset circuit 306 for resetting the inverter logic circuit 304, and an output terminal 308 for outputting the output signal OUT.

The logic circuit 304 includes a dynamic inverter 49 consisting of a PMOS transistor 50, and NMOS transistors 52 and 54; and a PMOS transistor 56 of a smaller size than the normal transistor size. The transistors 50, 52 and 54 has their conduction paths (i.e., channels) coupled in series between a first supply voltage terminal 310 (i.e., a higher supply voltage terminal $V_{DD}$) and a second supply voltage terminal 312 (i.e., a lower supply voltage terminal such as a ground terminal

$V_{SS}$) in order. Gates of the transistors 50 and 52 are coupled with each other. Transistor 54 has its gate applied with an input signal IN. Transistor 56 has its conduction path coupled between the first supply voltage terminal 310 and the drain junction node N10 of transistors 50 and 52 (i.e., output terminal 308), and its gate coupled to the second supply voltage terminal 312. The logic circuit 304 with the above arrangement functions as an inverter logic to perform the logic negation operation with respect to the input signal IN.

The reset circuit 306 includes two static CMOS inverters 70 and 160; a dynamic inverter 130 consisting of a PMOS transistor 64 and NMOS transistors 66 and 68; an inverting latch 140 consisting of two cross-coupled static inverters 72 and 74; a delay circuit 150 formed by, for example, an even number of serially-connected static inverters (not shown); and an S(set)-R(reset) latch or flipflop 182 constructed from two NAND logic gates 80 and 82 connected back to back. Conduction paths of the transistors 64, 66 and 68 are coupled in series between the first and second supply voltage terminals 310 and 312 in order. Gates of the transistors 64 and 66 are commonly coupled to the output terminal 308. The input signal IN is supplied through inverter 70 to gate of the transistor 68. One terminal of the inverting latch 140 is coupled with drain junction node N12 of the transistors 64 and 66 and the other terminal thereof is commonly coupled with the delay circuit 150 and input terminal of the inverter 160. One input of NAND logic gate 80, i.e., Set input of flipflop 182, is coupled with delay circuit 150, and the other input thereof is coupled to output of NAND logic gate 82. NAND logic gate 82 has its one input coupled to output of NAND logic gate 80 and its other input coupled to output of inverter 160. Output of NAND logic gate 82, i.e., negative output (generally represented by symbol $\overline{Q}$) of flipflop 182 is coupled with gates of transistors 50 and 52.

Now, the essential and principal operation of the self-resetting dynamic inverter logic circuit 300 will be described in detail below.

When input signal IN is at a logic low level, then NMOS transistor 54 is turned off and node N10 is charged by PMOS transistor 56 to a logic high level, along with output terminal 308 (or output signal OUT). With high level output signal OUT, node N12 goes low since NMOS transistors 66 and 68 both are turned on, so nodes N14 and N16 go high and low, respectively. S-R flipflop 182 thus provides its output of a high level to node N18 (the output of the flipflop 182 will not change unless its inputs change). NMOS transistor 52 becomes conductive. Therefore, dynamic inverter logic circuit 300 is ready for the change of input signal IN.

When input signal IN makes a transition from a logic low level to a logic high level while NMOS transistor 52 is conducting, node N10 is then discharged to a logic low level because NMOS transistor 54 also conducts together with the transistor 52. Therefore, the output signal OUT changes from a logic high level to a logic low level since the respective NMOS transistors 52 and 54 are larger than the PMOS transistor 56 in size.

The high-to-low transition of the output signal OUT is fed back to reset circuit 306, and thus PMOS transistor 64 conducts and NMOS transistors 66 and 68 become nonconductive, so that node N12 goes high. The logic high level on node N12 makes node N16 (i.e., the Reset input of S-R flipflop 182) high, output of the flipflop 182 with the high level Set input on node N14 then does not change and still remains high. After an elapse of a predetermined delay time (e.g., 0.5 to 1.5 nsec) given by delay circuit 150, node N14 goes low. This makes node N18 low so that NMOS transistor 52 and PMOS transistor 50 are rendered off and on, respectively, thereby causing node N10 (or output terminal 308) to be recharged to a high level. As a result, the inverter logic circuit 304 is reset by reset circuit 306; that is, the dynamic inverter logic circuit 300 is reset by itself with the lapse of the delay time of delay circuit 150. As will be understood by a person of ordinary skill in the pertinent art, the pulse width of the output signal OUT can be controlled by adjusting the delay time of the delay circuit 150 in a given operation cycle time.

The low-to-high transition of the output signal OUT is also fed back to reset circuit 306, so that PMOS and NMOS transistors 64 and 68 are turned off and on, respectively. At this time, firstly, in case the input signal IN has already gone low, nodes N12 and N16 go low and node N18 goes high. Thus, PMOS and NMOS transistors 50 and 52 are switched off and on, respectively, so that the dynamic inverter circuit 300 is ready for the low-to-high change of input signal IN. Secondly, when the input signal IN still remains high with the high level output signal OUT, although the transistor 68 is nonconductive, nodes N12 and N16 remain low and node N18 remains high with the help of the inverting latch 140, like the above case. Consequently, the dynamic inverter circuit 300 is also ready for the low-to-high change of input signal IN in this case. It will be well understood therefore that the dynamic logic circuit 300 enters a ready state independent of the pulse width of the input signal IN.

As described above, the high-to-low transition of the output signal OUT is transferred to the Set input of flipflop 182 via delay circuit 150 to insure a desired output signal pulse width. But, the low-to-high transition of the output signal OUT is directly fed back to the Reset input of flipflop 182 without delay in order to prepare for next operation cycle quickly. Such a circuit configuration allows the dynamic circuit 300 to enter a reset state only depending on the low-to-high transition of the output signal OUT and independent of input pulse width although the delay time change due to process and/or environment variations occurs, thereby resulting in stable reset operation and preventing operational errors in high speed applications.

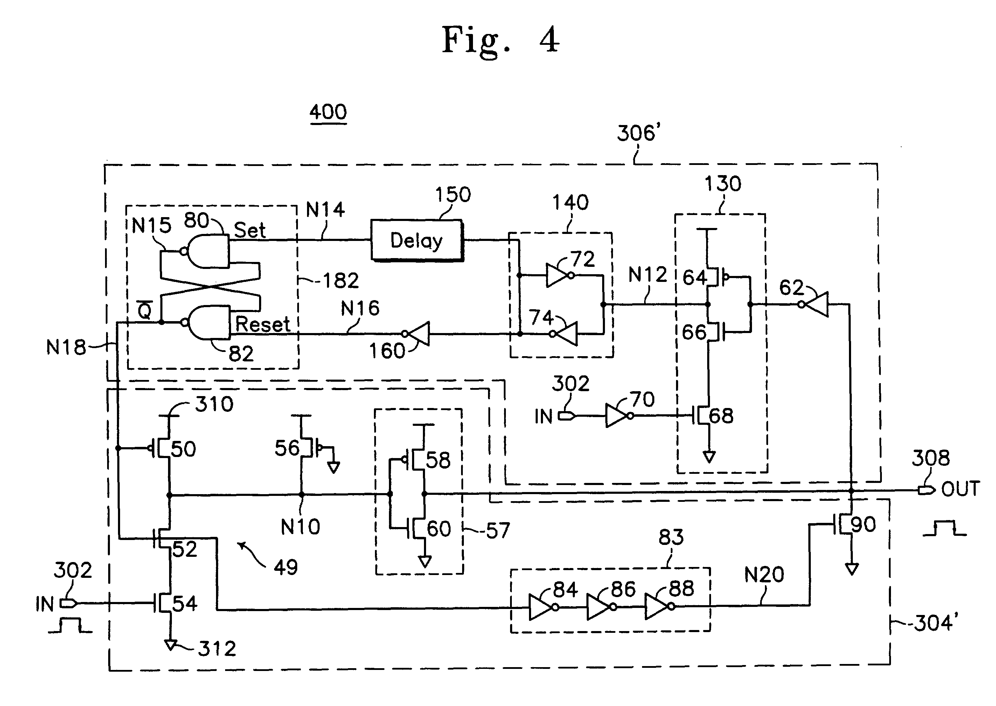

Fig. 4 shows a second embodiment of a self-resetting dynamic logic circuit according to the invention. Referring to Fig. 4, this embodied logic circuit 400 is a self-resetting dynamic buffer circuit, which has the same arrangement as that shown in Fig. 3 with exception that a static CMOS inverter 57, a delay circuit 83 and NMOS transistor 90 are additionally provided for buffer logic circuit 304', and a static inverter 62 for reset circuit 306'. In Fig. 4, the same parts as those shown in Fig. 3 are represented with like reference numerals and symbols and to avoid description duplication, accordingly, the explanation associated with their circuit configuration will be omitted.

Referring gain to Fig. 4, inverter 57 consisting of a larger PMOS transistor 58 and a smaller NMOS transistor 60 has its input coupled to node N10 and its output coupled to output terminal 308. Inverter 62 has its input coupled to output terminal 308 and its output coupled to the input of inverter 130. Delay circuit 83 constructed with three serially-connected static inverters 84, 86 and 88 is coupled between node N18 (or gate of transistor 52) and gate of transistor 90 having its conduction path coupled between output terminal 308 and second supply voltage terminal (i.e., $V_{SS}$) 312.

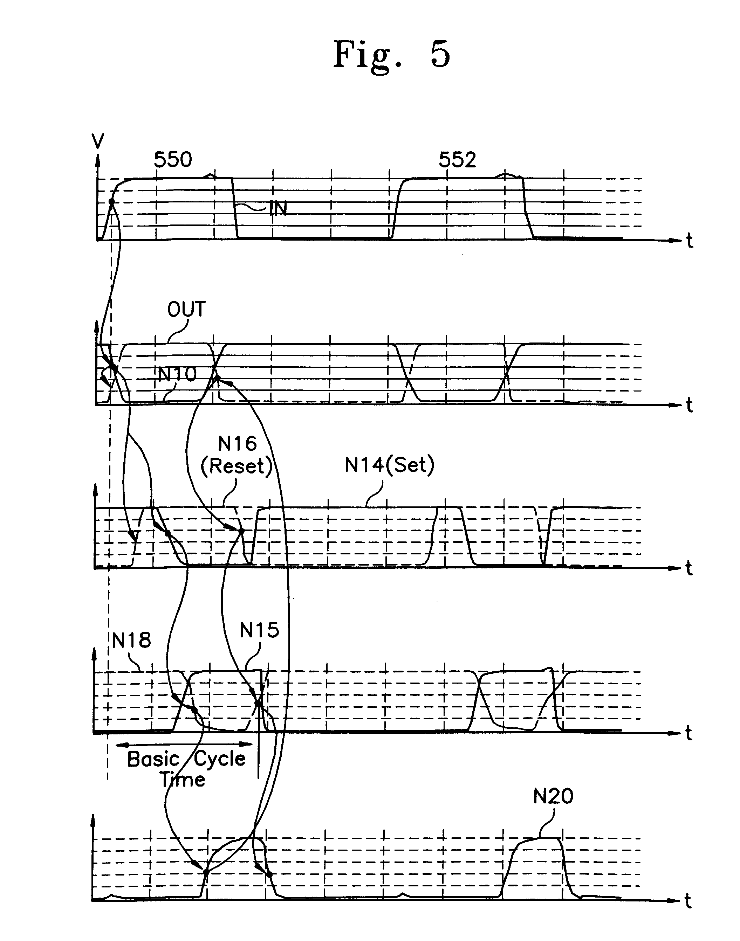

In Fig. 5, the timing relationship between the signals at selected points of the logic circuit of Fig. 4 is shown. The operation of the self-resetting dynamic buffer logic circuit 400 will be described below with reference to Figs. 4 and 5.

When input signal IN is at a logic low level, node N10 is charged to a logic high level and output terminal 302 remains low. With low level output signal OUT, node N12 goes low, so nodes N14 and N16 go high and low, respectively. S-R flipflop 182 thus provides its output of a high level to node N18. NMOS transistor 52 becomes conductive while NMOS transistor 90 is turned off. Thus, self-resetting dynamic buffer logic circuit 400 is ready for the change of input signal IN.

When input signal IN transitions from a logic low level to a logic high level (refer to 550 or 552) while NMOS transistor 52 is conducting, node N10 is then discharged to a logic low level because NMOS transistor 54 also conducts together with the transistor 52. The output signal OUT therefore changes from a logic low level to a logic high level depending on the voltage level on node N10.

The low-to-high transition of the output signal OUT is transferred to reset circuit 306', and thus PMOS transistor 64 conducts while NMOS transistors 66 and 68 are rendered off, causing node N12 to go high. The logic high level on node N12 makes node N16 (i.e., the Reset input of S-R flipflop 182) high, output of the flipflop 182 with the high level Set input on node N14 then does not change and still remains high. After a predetermined delay time (e.g., 0.5 to 1.5 nsec) of delay circuit 150 has elapsed, nodes N14 and N18 go low. So, PMOS transistor 50 is turned on while NMOS transistor 52 is turned off, thus node N10 is recharged to a high level. As a result, the buffer logic circuit 304' is reset by reset circuit 306'. Namely, the self-resetting dynamic buffer logic circuit 400 is reset by itself with the lapse of the delay time of delay circuit 150. The pulse width of the output signal OUT, of course, can be controlled by adjusting the delay time of the delay circuit 150 in a given operation cycle time.

The high-to-low transition of the output signal OUT is also fed back to reset circuit 306', so that PMOS and NMOS transistors 64 and 68 are turned off and on, respectively. At this time, if the input signal IN has already gone low, then nodes N12 and N16 go low and node N18 goes high. Thus, PMOS and NMOS transistor 50 and 52 are switched off and on, respectively, so that the dynamic buffer circuit 300 is ready for the next low-to-high change of input signal IN. Unlike this, when the input signal IN still remains high with the low level output signal OUT, although the transistor 68 non-conducts, nodes N12 and N 16 remain low and node N18 remains high with the help of the inverting latch 140. In this case, the dynamic buffer logic circuit 400 also enters a ready state independent of the pulse width of the input signal IN so as to be ready for the low-to-high change of input signal IN.

The low-to-high transition the output signal OUT is transferred to the Set input of flipflop 182 via delay circuit 150 to insure a desired output signal pulse width. However, the high-to-low transition of the output signal OUT is directly fed back to the Reset input of flipflop 182 without delay in order to prepare for next operation cycle quickly. Such a circuit configuration allows the dynamic circuit 400 to enter a reset state only depending on the high-to-low transition of the output signal OUT and independent of input pulse width although the delay time change due to process and/or environment variations occurs, thereby resulting in stable reset operation and preventing operational errors in high speed applications (such as processors, or memories) in which logic circuits are cascaded in a plurality of connected stages.

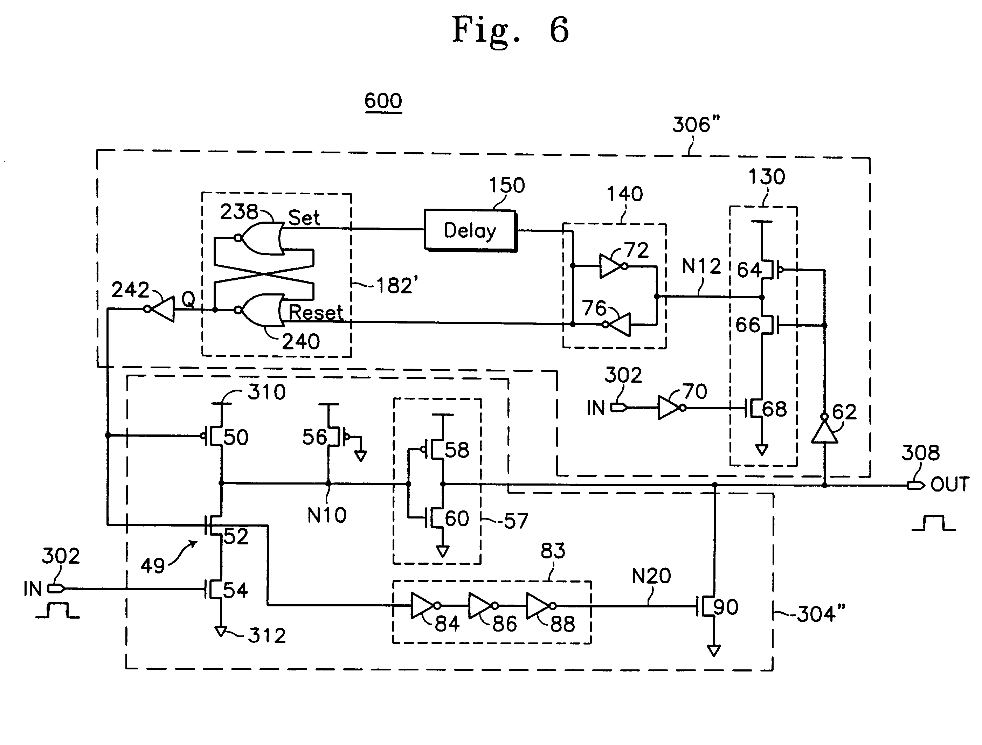

Fig. 6 illustrates a third embodiment of a self-resetting dynamic logic circuit according to the invention. Referring to Fig. 6, this embodied logic circuit 600 is a self-resetting dynamic buffer circuit, which has the same arrangement as that shown in Fig. 4 with exception that inverter 160, S-R flipflop 182 and delay 150 are respectively replaced by a static inverter 242, an S-R flipflop 182' consisting of NOR logic gates 238 and 240, and an inverting delay circuit 150' consisting of, for example, an odd number of serially-connected inverters (not shown). In Fig. 6, the same parts as those shown in Fig. 4 are represented with like reference numerals and to avoid description duplication, accordingly, their explanation will be omitted.

As shown in Fig. 6, S-R flipflop 182' has a Set input coupled with delay circuit 150 and a Reset input coupled with latch 140. Input of inverter 242 is coupled to positive output (generally represented by Q) of the flipflop 182' (i.e., output of NOR gate 240) and output of the inverter 242 is coupled in common to gates of transistors 50 and 52 and to delay circuit 82.

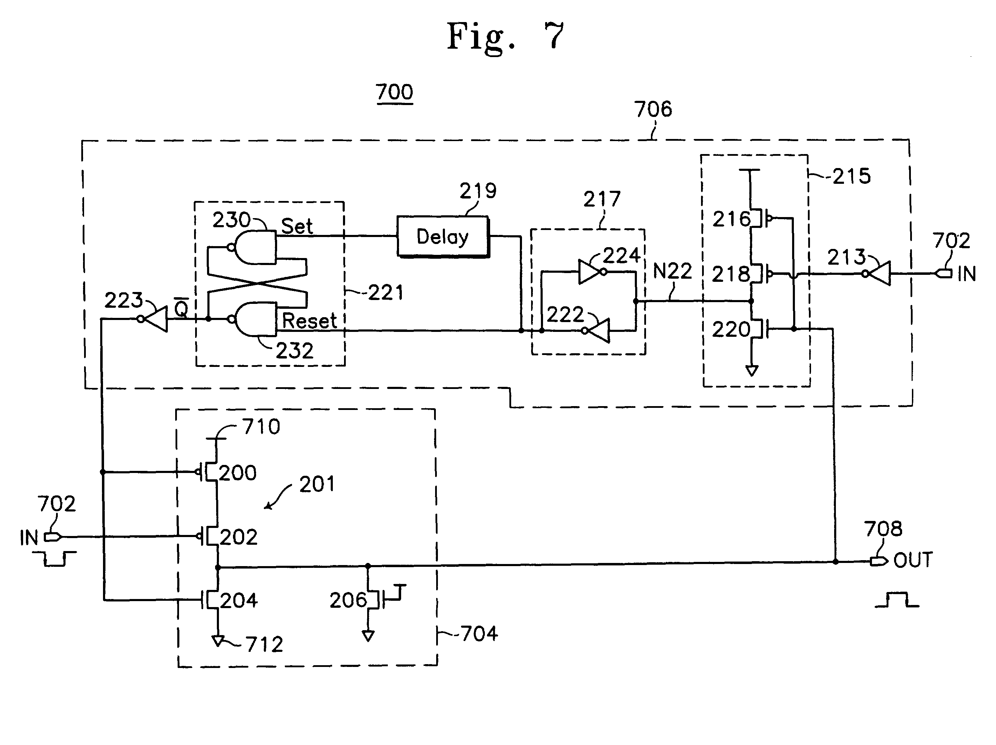

A fourth embodiment of a self-resetting dynamic logic circuit according to the invention is depicted in Fig. 7, wherein there is illustrated a self-resetting dynamic inverter logic circuit 700. This self-resetting logic circuit 700 includes an input terminal 702 for receiving an input signal IN, an inverter logic circuit 704 for inverting the input signal IN and providing an output signal OUT, a reset circuit 706 for resetting the inverter logic circuit 704, and an output terminal 708 for outputting the output signal OUT.

The logic circuit 704 includes a dynamic inverter 201 consisting of PMOS transistors 200 and 202, and an NMOS transistor 204; and a smaller NMOS transistor 206. The transistors 200, 202 and 204 have their conduction paths coupled in series between a higher supply voltage terminal ($V_{DD}$) 710 and a lower supply voltage terminal 712 such as a ground terminal ($V_{SS}$) in order. Gates of the transistors 200 and 204 are coupled with each other. Transistor 202 has its gate applied with an input signal IN. NMOS transistor 206 has its conduction path coupled between the higher supply voltage terminal 710 and the drain junction node of transistors 202 and 204 (i.e., output terminal 708), and its gate coupled to the higher supply voltage terminal 710. The logic circuit 704 with the above arrangement functions as an inverter logic to performs the logic negation operation with respect to the input signal IN.

The reset circuit 706 includes two static CMOS inverters 213 and 223; a dynamic inverter 215 consisting of PMOS transistors 216 and 218, and an NMOS transistor 220; an inverting latch 217 consisting of two cross-coupled static inverters 224 and 222; a delay circuit 219 formed by, for example, an odd number of serially-connected static inverters (not shown); and an S-R flipflop 221 constructed with two cross-coupled NAND logic gates 230 and 232. Conduction paths of the transistors 216, 218 and 220 are coupled in series between the higher and lower supply voltage terminals 710 and 712 in order. Gates of the transistors 216 and 220 are commonly coupled to the output terminal 708. The input signal IN is supplied through inverter 213 to gate of the transistor 218. One terminal of the inverting latch 217 is coupled with drain junction node N22 of the transistors 218 and 220 and the other terminal thereof is commonly coupled with the delay circuit 219 and a Reset input of flipflop 221. A Set input of flipflop 221 is coupled with delay circuit 219. Negative output ($\overline{Q}$) of flipflop 221 (i. e., output of NAND logic gate 232) is tied through inverter 223 to gates of transistors 200 and 204.

The operation of the self-resetting dynamic inverter logic circuit 700 will now be described.

When input signal IN remains enough at a logic high level, PMOS transistor 202 is turned off and output terminal 708 (or output signal OUT) is charged to a logic low level by means of NMOS transistor 206. With low level output signal OUT, node N22 goes high since PMOS transistors 216 and 218 both are turned on. So, a high level and a low level are applied to Set input and Reset input of S-R flipflop 219, respectively, with a predetermined time interval (i.e., delay time of delay circuit 219). The flipflop 221 then provides its negative output of a logic high level so that PMOS transistor 200 is driven on by inverter 223. Dynamic inverter logic circuit 700, therefore, is ready for the high-to-low change of input signal IN.

When input signal IN makes a transition from a logic high level to a logic low level while PMOS transistor 200 is conducting, output terminal 708 is then charged to a logic high level because NMOS transistor 206 has a much smaller size than PMOS transistors 200 and 202.

The low-to-high transition ofthe output signal OUT is fed back to reset circuit 706, and thus NMOS transistor 220 conducts while PMOS transistors 216 and 218 are turned off, so that node N22 goes low. The logic low level on node N22 makes the Reset input of S-R flipflop 221 high, output ($\overline{Q}$) of flipflop 221 still having the high level Set input does not change and remains high. After an elapse of a predetermined delay time (e. g., 0.5 to 1.5 nsec) given by delay circuit 219, a low level applied to the Set input of flipflop 230. This causes flipflop 221 to provide its output ofa low level, so PMOS transistor 200 and NMOS transistor are rendered off and on, respectively, thereby causing output terminal 708 to be pulled down to a low level. As a result, the inverter logic circuit 704 is reset by reset circuit 706. That is, the dynamic inverter logic circuit 700 is reset by itself with the lapse of the delay time of delay circuit 219. Note that the pulse width of the output signal OUT can be controlled by adjusting the delay time of the delay circuit 150 within a given operation cycle time.

The high-to-low transition ofthe output signal OUT is also fed back to reset circuit 706, so that PMOS transistor 216 is turned on. At this time, in case the input signal IN has already gone high, node N22 and Set input of flipflop 221 go low and thus PMOS and NMOS transistors 200 and 204 are switched off and on, respectively. Therefore, the dynamic inverter circuit 700 is ready for the high-to-low change of input signal IN. Unlike this, if the input signal IN still remains low with the low level output signal OUT, Set and Reset inputs of flipflop 221 are held at their previous states (i.e., low and high levels, respectively) with the help of inverting latch 217. The flipflop 221 thus provides its negative output of a low level so that PMOS and NMOS transistors 200 and 204 are turned off and on respectively and the low state of the output signal OUT is maintained stable.

As described above, it is also clear that the dynamic logic circuit 700 of this embodiment does not affected by the pulse width ofthe input signal IN. The low-to-high transition the output signal OUT is transferred to the Set input of flipflop 221 via delay circuit 219 to insure a desired output signal pulse width. But, the high-to-low transition of the output signal OUT is directly fed back to the Reset input of flipflop 221 without delay in order to prepare for next operation cycle quickly.

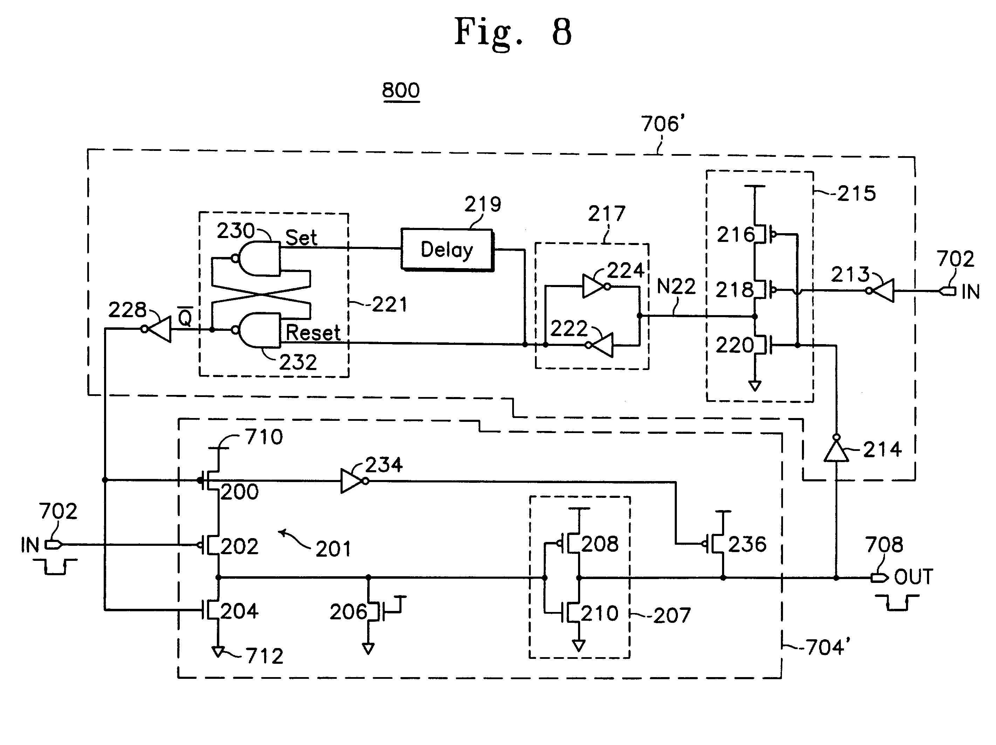

Referring to Fig. 8, there is illustrated a fifth embodiment of a self-resetting dynamic logic circuit according to the invention. This embodied logic circuit 800 is a self-resetting dynamic buffer circuit, which has the same arrangement as that shown in Fig. 7 with exception that static CMOS inverters 207 and 234, and PMOS transistor 236 are additionally provided for buffer logic circuit 704', and a static inverter 214 for reset circuit 706'. In Fig. 8, the same parts as those shown in Fig. 7 are represented with like reference numerals and symbols. The principal operation of this self-resetting dynamic buffer logic circuit 800 can be well understood well in the light of that of the circuit shown in Fig. 7 and, therefore, their explanation will be omitted herein.

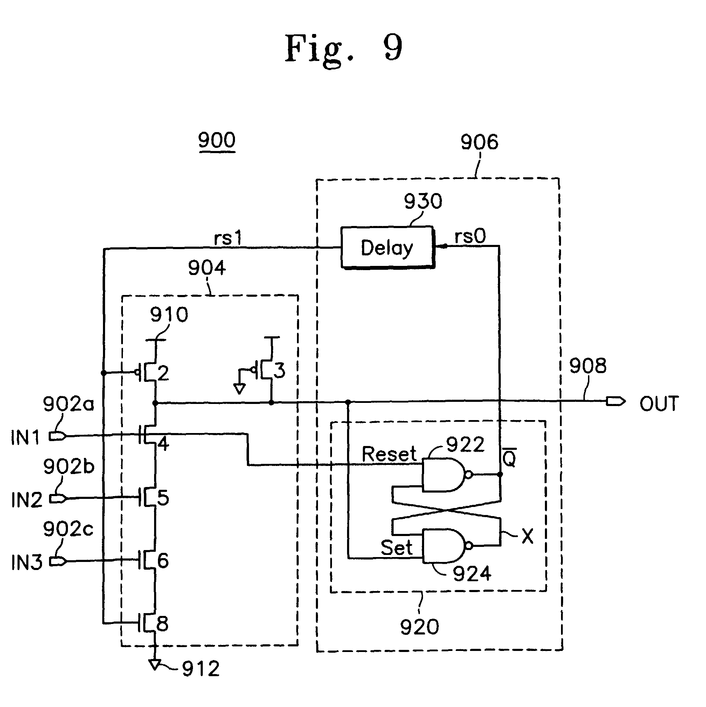

Fig. 9 shows a sixth embodiment ofa self-resetting dynamic logic circuit according to the invention. The dynamic logic circuit 900 shown in Fig. 9 is a self-resetting dynamic NAND logic circuit. The self-resetting dynamic NAND logic circuit 900 includes input terminals 902a, 902b and 902c for receiving input signals IN1, IN2 and IN3, respectively; a NAND logic circuit 904 for performing the logical NAND operation with respect to the input signals IN1, IN2 and IN3, and providing an output signal OUT; a reset circuit 906 for resetting the NAND logic circuit 904; and an output terminal 908 for outputting the output signal OUT.

The NAND logic circuit 904 is formed by PMOS transistors 2 and 3, and NMOS transistors 4, 5, 6 and 8. Conduction paths of transistors 2, 4, 5, 6 and 8 are coupled in series between a higher supply voltage terminal ($V_{DD}$) 910 and a lower supply voltage terminal ($V_{SS}$) 912 in order. Input signals IN1, IN2 and IN3 are applied to gates of NMOS transistors 4, 5 and 6, respectively. PMOS transistor 3 of a smaller size than normal transistor size has its conduction path coupled between the higher supply voltage terminal 910 and the output terminal 908 (or the drain junction nodes of transistors 2 and 4) and its gate coupled to the lower supply voltage terminal 912. The reset circuit 906 is constructed with an S-R flipflop 920 made up of two NAND logic gates 922 and 924 connected back to back, and a delay circuit 930 consisting of, for example, an even number of serially-connected inverters (not shown). S-R flipflop 920 has its Set input coupled with the output terminal 908 and its Reset input supplied with the input signal IN1. One end of delay circuit 930 is coupled with negative output ($\overline{Q}$) of flipflop 920, and the other end thereof is commonly coupled with gates of transistors 2 and 8.

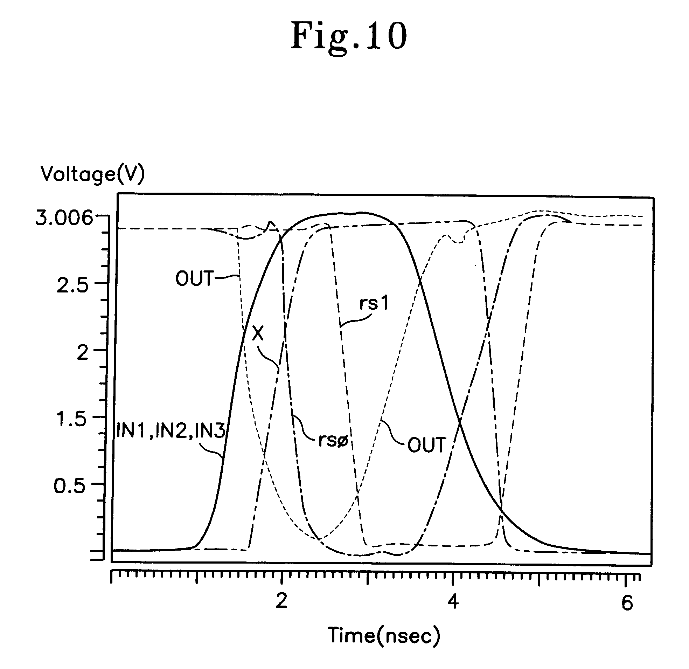

Fig. 10 is a timing diagram illustrating the timing relationship between the signals at selected points ofthe circuit of Fig. 9. The operation ofthe self-resetting dynamic logic circuit 900 will be described with reference to Figs. 9 and 10.

When all input signals IN1, IN2 and IN3 are low, NMOS transistors 4, 5 and 6 are turned off and S-R flipflop 920 produces its negative output ($\overline{Q}$) (i.e., reset signal rs0) of a high level. Delay circuit 930 having a predetermined delay time (about 1 nsec) delays the reset signal rs0 and produces a delayed reset signal rsl of a high level. PMOS transistor 2 and NMOS transistor 8 are turned off and on respectively in response to the delayed reset signal rs1, and thus output terminal 908 is charged by PMOS transistor 3 to a high level. Self-resetting dynamic NAND logic circuit 900, therefore, is ready for the change of input signals IN1, IN2 and IN3.

When all the input signals IN1, IN2 and IN3 become high as shown in Fig. 10, output signal OUT on output terminal 908 goes low since all of NMOS transistors 4, 5, 6 and 8 which are larger than PMOS transistor 3 in size, become conductive. The low level on output terminal 908 makes negative output ($\overline{Q}$) of flipflop 920 or reset signal rs0 low. With the lapse of the given delay time of delay circuit 930, the reset signal rs1 goes low and transistors 2 and 8 are switched on and off, respectively. This causes the output signal OUT to be recharged to a high level quickly even though the input signals IN 1, IN2 and IN3 are still remain high, as shown in Fig. 10. That is, NAND logic circuit 904 is reset by reset circuit 906 regardless of the pulse widths ofthe input signals IN1, IN2 and IN3. The pulse width of output signal OUT can be controlled by adjusting the delay time of delay circuit 930.

Thereafter, when the input signal IN1 goes low, the reset signals rs0 and rsl go high since flipflop 920 produces its negative output ($\overline{Q}$) of a high level. So, NAND logic circuit 904 enters a ready state in which NMOS transistor 8 is conducting and ready for the change of input signals IN1, IN2 and IN3.

The self-resetting dynamic NAND logic circuit 900 of Fig. 9 can be utilized for decoder circuits of memory devices. In Fig. 9, if the source-drain junction node of transistors 4 and 5 and that of transistor 6 and 8 are short-circuited, such a circuit can function as a self-resetting dynamic inverter logic circuit with respect to a single input signal IN1.

All of the above-described embodiments of the present invention can be implemented into high speed processors, memories, or other integrated circuits, in which logic circuits are cascaded in a plurality of connected stages.

Various modification will become possible for those skilled in the art after reviewing the teachings of the present disclosure without departing from the scope thereof.

**Claims**

1. A self-resetting logic circuit, comprising:

    a logic circuit which has one or more inputs for receiving one or more input signals and one or more outputs for providing an output signal; and
    a reset circuit for resetting said logic circuit in response to transitions ofthe output signal, independent of pulse widths of the respective input signals.

2. The self-resetting logic circuit of Claim 1, wherein said reset circuit comprises:

an output feedback circuit for receiving the output signal and transmitting leading and trailing edge transitions of the output signal to next stage;
a delay circuit of a predetermined delay time, having a first end coupled to said output feedback circuit and a second end; and
an S-R flipflop having a set input coupled to the second end of said delay circuit, a reset input coupled to said output feedback circuit, and an output coupled to said logic circuit.

3. The self-resetting logic circuit of Claim 2, wherein pulse width of the output signal is determined by the predetermined delay time of said delay circuit.

4. The self-resetting logic circuit of Claim 3, wherein said S-R flipflop is formed by NAND logic gates.

5. The self-resetting logic circuit of Claim 3, wherein said S-R flipflop is formed by NOR logic gates.

6. The self-resetting logic circuit of Claim 1, wherein said reset circuit comprises:

an S-R flipflop having a set input for receiving said output signal, a reset input for receiving one of the input signals, and an output for providing a reset signal; and
a delay circuit of a predetermined delay time, coupled between said logic circuit and the output of said S-R flipflop.

7. A self-resetting logic circuit, comprising:

an input terminal for receiving an input signal;
an output terminal for providing an output signal;
a logic circuit coupled between said input and output terminals; and
a reset circuit said output terminal and said logic circuit;

wherein said reset circuit includes:

a first PMOS transistor having a source coupled to a first supply voltage terminal for providing a first supply voltage, a drain coupled to a first node, and a gate coupled to said output terminal;
a first NMOS transistor having a source, a drain coupled to the first node, and a gate coupled to said output terminal;

a second NMOS transistor having a source coupled to a second supply voltage terminal for providing a second supply voltage lower than the first supply voltage, a drain coupled to the source of said first NMOS transistor, and a gate;
a first inverter having an input coupled to said input terminal and an output coupled to the gate of said second NMOS transistor;
an inverting latch having a first end coupled to the first node and a second end;
a second inverter having an input coupled to the second end of said inverting latch and an output;
a dely circuit of a predetermined delay time, having a first end coupled to the second end of said inverting latch and a second end; and
an S-R flipflop having a set input coupled to the second end of said delay circuit, a reset input coupled to the output of said second inverter, and a negative output coupled to said logic circuit.

8. The self-resetting logic circuit of Claim 7, wherein said S-R flipflop is formed by NAND logic gates.

9. The self-resetting logic circuit of Claim 8, wherein said delay circuit comprises an even number of serially-connected inverters.

10. The self-resetting logic circuit of Claim 7, wherein said logic circuit is an inverter logic circuit.

11. The self-resetting logic circuit of Claim 7, wherein said logic circuit is a buffer logic circuit, said reset logic circuit further includes an inverter having an input coupled to said output terminal and an output commonly coupled to the gates of said first PMOS transistor and said first NMOS transistor.

12. A self-resetting logic circuit, comprising:

an input terminal for receiving an input signal;
an output terminal for providing an output signal;
a logic circuit coupled between said input and output terminals; and
a reset circuit said output terminal and said logic circuit;

wherein said reset circuit includes:

a first PMOS transistor having a source coupled to a first supply voltage terminal for providing a first supply voltage, a drain coupled to a first node, and a gate coupled to said output terminal;
a first NMOS transistor having a source, a drain coupled to the first node, and a gate coupled to said output terminal;

a second NMOS transistor having a source coupled to a second supply voltage terminal for providing a second supply voltage lower than the first supply voltage, a drain coupled to the source of said first NMOS transistor, and a gate;

a first inverter having an input coupled to said input terminal and an output coupled to the gate of said second NMOS transistor;

an inverting latch having a first end coupled to the first node and a second end;

a dely circuit of a predetermined delay time, having a first end coupled to the second end of said inverting latch and a second end;

an S-R flipflop having a set input coupled to the second end of said delay circuit, a reset input coupled to the second end of said inverting latch, and a negative output; and

a second inverter having an input coupled to the negative output of said S-R flipflop and an output coupled to said logic circuit.

13. The self-resetting logic circuit of Claim 12, wherein said S-R flipflop is formed by NOR logic gates.

14. The self-resetting logic circuit of Claim 13, wherein said delay circuit comprises an odd number of serially-connected inverters.

15. The self-resetting logic circuit of Claim 12, wherein said logic circuit is an inverter logic circuit.

16. The self-resetting logic circuit of Claim 12, wherein said logic circuit is a buffer logic circuit, said reset logic circuit further includes an inverter having an input coupled to said output terminal and an output commonly coupled to the gates of said first PMOS transistor and said first NMOS transistor.

17. A method for resetting a logic circuit which has one or more inputs for receiving one or more input signals and an output for providing an output signal, said method comprising the steps of:

detecting a leading edge of the output signal;
producing a first reset signal in response to the detection ofthe leading edge ofthe output signal;
delaying the first reset signal;
resetting said logic circuit in response to the delayed first reset signal;
detecting a trailing edge of the output signal;
producing a second reset signal in response to the detection ofthe trailing edge of the output signal; and
forcing said logic circuit to be ready for next in-

put signals.

# Fig. 1

EP 0 928 069 A2

EP 0 928 069 A2

# Fig. 2A

Correct Reset Point · Actual Reset Point

12

# Fig. 2B

# Fig. 3

# Fig. 4

**400**

# Fig. 5

Fig. 6

Fig. 7

700

Fig. 8

# Fig. 9

# Fig.10